# EUROPÄISCHE PATENTSCHRIFT

(11) **EP 0 657 941 B1**
(45) Veröffentlichungstag und Bekanntmachung des Hinweises auf die Patenterteilung: **20.08.1997**
(21) Anmeldenummer: 94118593.6
(22) Anmeldetag: 25.11.1994
(51) Int. Cl.: H01L 29/10, H01L 29/08, H01L 29/739, H01L 29/74, H01L 21/331, H01L 21/332

(54) **Steuerbares Leistungshalbleiterbauelement mit Pufferzone und Verfahren zu dessen Herstellung**
Gated power semiconductor device having a buffer zone and method of making the same
Dispositif semi-conducteur de puissance contrôlable comprenant une zone tampon et méthode de fabrication correspondante

(30) Priorität: 08.12.1993 DE 4341879
(43) Veröffentlichungstag der Anmeldung: 14.06.1995
(73) Patentinhaber: SIEMENS AKTIENGESELLSCHAFT, 80333 München (DE)
(72) Erfinder: Brunner, Heinrich, Dr., D-81667 München (DE); Gerstenmaier, York Christian, Dr., D-80638 München (DE)

(56) Entgegenhaltungen:
- EP-A- 0 200 863
- EP-A- 0 330 122
- EP-A- 0 501 342
- EP-A- 0 526 084
- FR-A- 2 394 175
- PATENT ABSTRACTS OF JAPAN, vol. 10, no. 129 (E-403) 14. Mai 1986; & JP-A-60 260 151

## Beschreibung

Steuerbare Leistungshalbleiterbauelemente sind aus EP-A-0 330 122 oder aus dem IEEE-Paper zum 5th International Symposium on Power Semiconductor Devices and IC's mit dem Titel "A High Power IGBT Module For Traction Motor Drive" von M. Mori et al. (Seiten 287 bis 291) bekannt. Bei steuerbaren Leistungshalbleiterbau-elementen, wie beispielsweise IGBT's (Insulated Gate Bipolar Transistor) und Thyristoren, wird beispielsweise oftmals eine n⁺-Pufferzone zwischen einer n⁻-Basiszone und einem p-Emitter vorgesehen, da aufgrund dessen eine Begrenzung der Raumladungszone möglich ist und zu einer kürzeren Basis führt, wodurch ein geringerer Durchlaßwiderstand erreichbar ist. Um die Latch-up-Neigung zu verkleinern und damit die Durchbruchsspannung zu erhöhen, wird die Ladungsträgerlebensdauer in der n⁻-Basis, beispielsweise durch Platindiffusion oder Elektronenbestrahlung verkleinert, wodurch beim Abschalten des steuerbaren Leistungshalbleiterbauelementes jedoch ein sogenannter Tail-Strom auftritt, der nachteiligerweise temperaturabhängig ist.

Der Erfindung liegt nun die Aufgabe zugrunde, ein steuerbares Leistungshalbleiterbauelement mit niedrigem Durchlaßwiderstand und hoher Durchbruchsspannung anzugeben, bei dem beim Ausschalten ein Tail-Strom auftritt, der nahezu temperaturunabhängig ist. Die Erfindung betrifft ein steuerbares Leistungshalbleiter-bauelement nach dem Patentanspruch 1.

Der mit der Erfindung erzielbare Vorteil liegt insbesondere darin, daß trotz einer vorhandenen n-Pufferschicht keine Senkung der Ladungsträgerlebensdauer zum Beispiel durch eine Platin-Diffusion oder eine Elektronenbestrahlung erforderlich ist und daß die steuerbaren Leistungshalbleiterbauelemente für einen weiten Strom und Spannungsbereich technisch einfach herstellbar sind.

Die Patentansprüche 2 und 3 sind auf bevorzugte Ausgestaltungen des erfindungsgemäßen Leistungshalbleiterbauelements gerichtet.

Die Patentansprüche 4 und 5 betreffen Verfahren zur Herstellung der erfindungsgemäßen steuerbaren Leistungshalbleiterbauelemente.

Die Erfindung wird nachfolgend anhand der Zeichnung naher erläutert. Dabei zeigt
- Figur 1: ein erfindungsgemäßes Leistungshalbleiterbauelement in Form eines IGBT's,
- Figur 2: ein erfindungsgemäßes Leistungshalbleiterbauelement in Form eines Thyristors,
- Figur 3: ein Zwischenprodukt bei der Herstellung eines erfindungsgemäßen Leistungshalbleiterbauelements und
- Figur 4: ein Strom/Zeit-Diagramm für ein erfindungsgemäßes und ein bekanntes Leistungshalbleiterbauelement für zwei unterschiedliche Temperaturen.

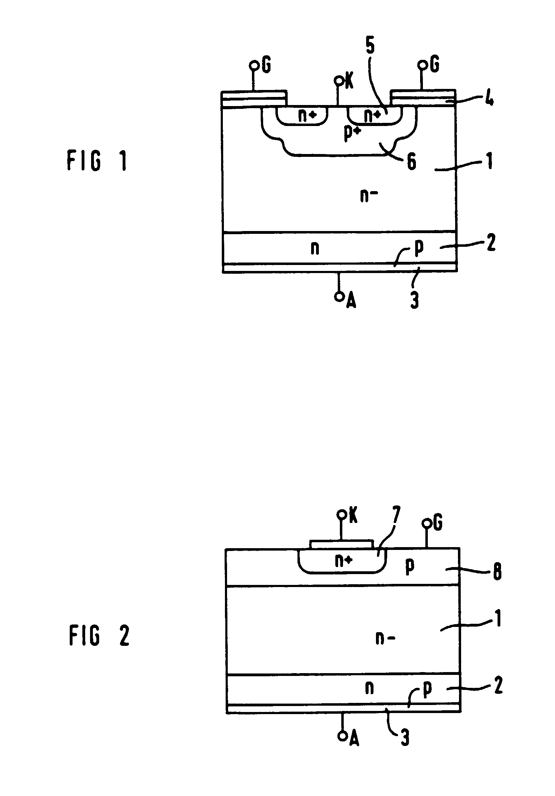

In Figur 1 ist ein erfindungsgemäßes steuerbares Leistungshalbleiterbauelement in Form eines IGBT's (Insulated Gate Bipolar Transistor) dargestellt, bei der der Reihe nach eine kathodenseitige Struktur 4 ... 6, eine n⁻-Basiszone 1, eine n-Pufferzone 2 und eine p-Emitterzone 3 vorgesehen sind. Die kathodenseitige Struktur 4 ... 6 besteht darin, daß mindestens ein n⁺-dotiertes Gebiet 5 durch ein p⁺-dotiertes Gebiet von der n⁻-Basiszone 1 getrennt ist und das p⁺-dotierte Gebiet 6 mit einem Kathodenanschluß K kontaktiert ist sowie mindestens eine Gateelektrode, die mit einem Gateanschluß G verbunden ist, und einen Teil des n⁺-dotierten Gebietes 5, einen Teil des p⁺-dotierten Gebietes 6 und einen Teil der n⁻-Basiszone 1 überdeckt, wobei die Gateelektrode von diesen Gebieten der n⁻-Basiszone durch eine Isolationsschicht 4 getrennt ist. Die p-Emitterzone 3 ist elektrisch leitend mit einem Anodenanschluß A verbunden.

Die Abmessungen und Dotierungskonzentrationen hinsichtlich der kathodenseitigen Struktur entsprechen denen herkömmlicher IGBT's.

Die Dicke der n⁻-Basiszone 1 kann wie üblich mit ca. 100 µm pro kV gewählt werden und die Dotierungskonzentration liegt typischerweise zwischen 8 x 10¹² und 10¹⁴ cm⁻³. Bei einem typischen Sperrspannungswert von 3 kV liegt die Länge der n⁻-Basis und damit im wesentlichen auch die Substratdicke bei ca. 300 µm.

Beim erfindungsgemäßen IGBT weist die n-Pufferzone 2 eine Dicke von ca. 20 bis 80 µm auf und besitzt am anodenseitigen Rand eine Dotierungskonzentration von 8 x 10¹³ bis 5 x 10¹⁴ cm⁻³. Der p-Emitter 3 ist im Vergleich zu bekannten Bauelementen mit einer Dicke von 400 bis 1000 nm und typischerweise 600 nm vergleichsweise flach ausgeführt und weist am anodenseitigen Rand eine tierungskonzentration von 10¹⁷ bis 10¹⁸ cm⁻³ auf.

Die Ladungsträgerlebensdauer der n⁻-Basiszone 1 ist in jedem Fall größer als 10 µs und weist typische Werte von ca. 80 µs auf, da keine zusätzlichen Rekombinationszentren vorgesehen sind. Das Ansteigen der Ladungsträgerlebensdauer wirkt sich in diesem Falle kaum auf die Ladungsträgerdichte aus da sie sich bereits auf einem hohen Niveau befindet.

Die Dotierung der n-Pufferzone 2 ist dabei so niedrig gewählt, daß sie nur einen sehr geringen Einfluß auf das Injektions-verhalten des flachen p-Emitters 3 besitzt. Die Dotierstoffmenge des Emitters 3 ist so gering gewählt, daß quasi keine Ladungsträgerrekombination im Emitter 3 stattfindet, sondern im Metallkontakt. Infolgedessen ist die Schwellenspannung zwischen den Schichten 2 und 3, im Gegensatz zu bekannten Leistungshalb-leiterbauelementen, temperaturunabhängig und die Ladungsträger-lebensdauer kann vergleichsweise lang gewählt werden, wodurch das erfindungsgemaße Halbleiterbauelement gegenüber Temperaturschwankungen weitaus unempfindlicher und der Tail-Strom von der Temperatur praktisch unabhängig ist. Die Dotierung der n-Pufferzone 2 ist jedoch ausreichend, daß ein sogenanntes Durchgreifen der Raumladungszone bis zum p-Emitter vermieden wird, wodurch, auch bei vergleichsweise hohen Sperrspannungen, die ohmschen Verluste in der n⁻-Basis gering sind, da aufgrund der Pufferschicht 2 die Basislänge geringer sein kann.

In Figur 2 ist ein erfindungsgemaßes Leistungshalbleiter-bauelement in Form eines Thyristors gezeigt, der sich lediglich durch die kathodenseitige Struktur 7, 8 von dem in Figur 1 dargestellten erfindungsgemaßen Leistungshalbleiterbauelement unterscheidet. Die kathodenseitige Struktur 7, 8 besteht dabei aus einer p-dotierten Zone, die mit dem Gateanschluß verbunden ist und in die ein n⁺-dotiertes Gebiet 7 eingebracht ist, wobei das n⁺-dotierte Gebiet 7 mit einer Elektrode elektrisch kontaktiert ist, die mit dem Kathodenanschluß K elektrisch leitend verbunden ist.

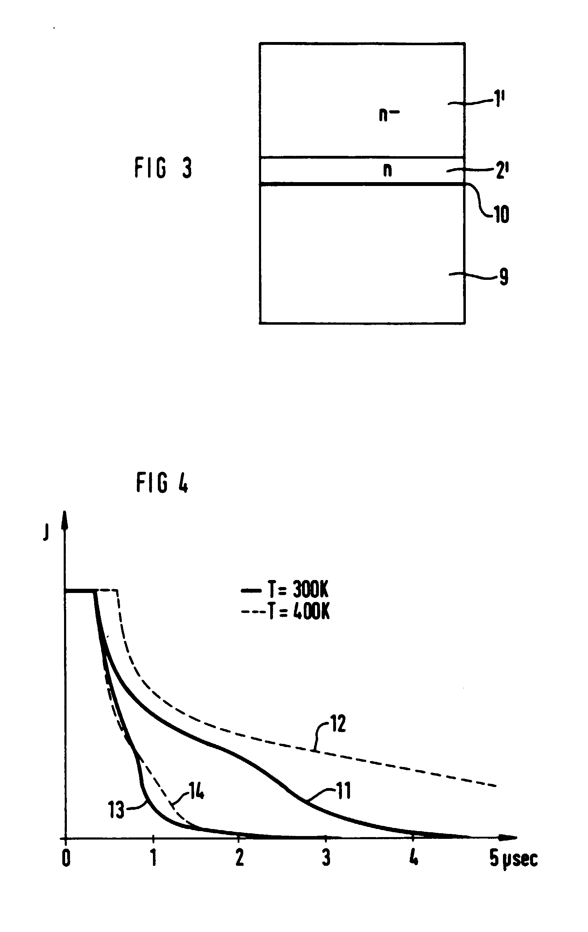

Zur Erläuterung eines erfindungsgemaßen Verfahrens zur Herstellung eines erfindungsgemaßen steuerbaren Leistungshalbleiterbauelements ist in Figur 3 ein Zwischenprodukt dargestellt, das der Reihe nach aus einer n⁻-dotierten Zone 1', einer n-dotierten Zone 2' und einer Trägerschicht 9 besteht. In der Regel sind dabei die Schichten 1', 2' und 9 aus Silizium, wobei die Trägerschicht 9 undotiert oder eine beliebige Dotierung aufweisen kann. Typischerweise sind die Schichten 1' und 2' zusammen ca. 300 µm und die Trägerschicht ebenfalls ca. 300 µm dick.

Da Scheiben mit Durchmessern, wie sie für Leistungshalbleiterbauelemente üblich sind, in dieser Dicke vergleichsweise schlecht prozessierbar sind, wird die n-Pufferschicht 2' mit der Trägerschicht 9 (support wafer) an der Kontaktfläche (10) zwischen beiden Schichten durch sogenanntes "direct wafer bonding" verbunden.

Nähere Angaben hierzu sind beispielsweise aus dem Japanese Journal of Applied Physics, Vol. 27, No. 12, December 1988, pp. L2364-L2366 zu entnehmen.

Bei der erfindungsgemäßen Herstellung des erfindungsgemäßen steuerbaren Leistungshalbleiterbauelementes wird eine Scheibe aus einem n⁻-dotierten Silizium-Substrat 1' als Ausgangsmaterial verwendet. Die n-Pufferschicht 2' wird entweder durch epitaktisches Aufwachsen oder durch Eindiffundieren von zum Beispiel Phosphor-Atomen in das n⁻-Substrat erzeugt. Daraufhin erfolgt, wie in Figur 3 dargestellt, die Verbindung der Scheibe aus dem n⁻-dotierten Siliziumsubstrat und der weiteren Scheibe 9, die als Trägersubstrat dient. Die verbundenen Scheiben 1' und 9 weisen nun eine ausreichende Dicke auf und können so einem weiteren Prozeßschritt zur Erzeugung der jeweiligen kathodenseitigen Struktur zugeführt werden. Die Erzeugung der jeweiligen kathodenseitigen Struktur erfolgt in an sich bekannter Weise, zum Beispiel durch Diffusion. Da die weitere Scheibe nur als Trägersubstrat dient, wird sie nach der Erzeugung der kathodenseitigen Struktur durch Abschleifen entfernt. Dem Schleifvorgang kann sich zur Verbesserung der Oberflächen-eigenschaften gegebenenfalls ein Ätzschritt anschließen. Zum Schluß wird von der geschliffenen und gegebenenfalls geätzten Oberfläche die p-Emitterzone 3 durch Implantation erzeugt, wobei die Implantation in an sich bekannter Weise erfolgt.

In Figur 4 ist in einem Diagramm der zeitliche Verlauf des Laststromes I in einem Zeitintervall zwischen 0 und 5 µs nach dem Abschalten gezeigt. Dabei sind Stromverläufe 11 .. 14 eingetragen, wobei Verlauf 11 einem vergleichbaren konventionellen Leistungshalbleiterbauelement bei einer Temperatur von T=300K, wobei Verlauf 12 dem vergleichbaren konventionellen stungshalbleiterbauelement bei einer Temperatur von T=400K, wobei Verlauf 13 einem erfindungsgemäßen Leistungshalbleiterbauelement bei der Temperatur von T=300K und wobei Verlauf 14 dem erfindungsgemäßen Leistungshalbleiter-bauelement bei der Temperatur von T=400K entspricht.
Hierbei wird deutlich, daß die Verläufe 13 und 14 wesentlich schneller auf den Wert Null abklingen als die Veläufe 11 und 12 und daß die Verläufe 13 und 14, im Gegensatz zu den Verläufen 11 und 12, weitgehend identisch, also temperaturunabhängig sind. Beim Verlauf 12 tritt ein wesentlich langsamerer Stromabfall auf und selbst der Beginn des Abfalls erfolgt später als beim Verlauf 11.

## Patentansprüche

1. Steuerbares Leistungshalbleiterbauelement,
bei dem der Reihe nach eine kathodenseitige Struktur (4 ... 8), die je einen Kathodenanschluß (K) und einen Gateanschluß (G) aufweist, eine n⁻-Basiszone (1), eine n-Pufferzone (2) und eine mit einem Anodenanschluß (A) elektrisch kontaktierte p-Emitterzone (3) vorgesehen sind,
wobei die n-Pufferzone eine Dicke zwischen 20 und 80 µm und eine Dotierungskonzentration am anodenseitigen Rand von 8 x 10¹³ bis 5 x 10¹⁴ cm⁻³ aufweist, wobei die p-Emitterzone eine Dicke von 400 bis 1000 nm und eine Dotierungskonzentration am anodenseitigen Rand von 10¹⁷ bis 10¹⁸ cm⁻³ besitzt und wobei die n⁻-Basiszone (1) eine Ladungsträgerlebensdauer aufweist, die größer als 10 µs beträgt.

2. Steuerbares Leistungshalbleiterbauelement nach Anspruch 1,
**dadurch gekennzeichnet,**
daß das steuerbare Leistungshalbleiterbauelement einen Bipolartransistor mit isoliertem Gate darstellt, wobei die kathodenseitige Struktur (4 ... 6) mindestens ein n⁺-dotiertes Gebiet (5) aufweist, das durch ein p⁺-dotiertes Gebiet von der n⁻-Basiszone (1) getrennt ist, wobei mindestens eine Gateelektrode mit dem Gateanschluß (G) verbunden ist und einen Teil des n⁺-dotierten Gebietes (5), einen Teil des p⁺-dotierten Gebietes (6) und einen Teil der n⁻-Basiszone (1) überdeckt und wobei die Gateelektrode von diesen Gebieten und der n⁻-Basiszone durch eine Isolationsschicht (4) getrennt ist.

3. Steuerbares Leistungshalbleiterbauelement nach Anspruch 1,
**dadurch gekennzeichnet,**
daß das steuerbare Leistungshalbleiterbauelement einen Thyristor darstellt, wobei die kathodenseitige Struktur (7, 8) eine p-dotierte Zone (8) aufweist, die mit dem Gateanschluß (G) verbunden ist und in die ein n⁺-dotiertes Gebiet (7) eingebracht ist und wobei das n⁺-dotierte Gebiet (7) mit einer Elektrode elektrisch kontaktiert ist, die mit dem Kathodenanschluß (K) elektrisch leitend verbunden ist.

4. Verfahren zur Herstellung eines steuerbaren Leistungshalbleiterbauelementes nach einem der vorhergehenden Ansprüche,
wobei eine Scheibe aus n⁻-dotiertem Silizium als Substrat verwendet wird, wobei in einem ersten Schritt auf das Substrat die n-Pufferzone (2) durch Epitaxie aufgebracht wird, wobei in einem zweiten Schritt die n-Pufferzone mit einer weiteren Siliziumscheibe (9) durch Bonden verbunden wird, so daß die mechanische Stabilität erhöht wird, wobei in einem dritten Schritt die kathodenseitige Struktur erzeugt wird, wobei in einem vierten Schritt die weitere Scheibe aus Silizium durch Abschleifen entfernt wird und wobei in einem letzten Schritt die p-Emitterzone (3) durch Implantation erzeugt wird.

5. Verfahren zur Herstellung eines steuerbaren Leistungshalbleiterbauelementes nach einem der vorhergehenden Ansprüche,
wobei eine Scheibe aus n⁻-dotiertem Silizium als Substrat verwendet wird, wobei in einem ersten Schritt auf das Substrat die n-Pufferzone (2) durch Epitaxie aufgebracht wird, wobei in einem zweiten Schritt die n-Pufferzone (2) durch Eindiffundieren von Phosphor-Atomen erzeugt wird, wobei in einem dritten Schritt die Katodenseitige Struktur erzeugt wird, wobei in einem vierten Schritt die weitere Scheibe aus Silizium durch Abschleifen entfernt wird und wobei in einem letzten Schritt die p-Emitterzone (3) durch Implantation erzeugt wird.

## Claims

1. Controllable power semiconductor component,
in which there are provided, in order, a cathode-side structure (4 ... 8), which has in each case one cathode terminal (K) and one gate terminal (G), an n⁻-type base zone (1) an n-type buffer zone (2) and a p-type emitter zone (3) with which electrical contact is made by means of an anode terminal (A),
the n-type buffer zone having a thickness of between 20 and 80 µm and a doping concentration at the anode-side edge of 8 x 10¹³ to 5 x 10¹⁴ cm⁻³, the p-type emitter zone having a thickness of 400 to 1000 nm and a doping concentration at the anode-side edge of 10¹⁷ to 10¹⁸ cm⁻³, and the n⁻-type base zone (1) having a charge carrier life which is greater than 10 µs.

2. Controllable power semiconductor component according to Claim 1, characterized in that the controllable power semiconductor component constitutes an insulated gate bipolar transistor, the cathode-side structure (4 ... 6) having at least one n⁺-doped region (5) which is isolated from the n⁻-type base zone (1) by a p⁺-doped region, at least one gate electrode being connected to the gate terminal (G) and covering part of the n⁺-doped region (5), part of the p⁺-doped region (6) and part of the n⁻-type base zone (1), and the gate electrode being isolated from these regions and from the n⁻-type base zone by an insulation layer (4).

3. Controllable power semiconductor component according to Claim 1, characterized in that the controllable power semiconductor component constitutes a thyristor, the cathode-side structure (7, 8) having a p-doped zone (8) which is connected to the gate terminal (G) and into which an n⁺-doped region (7) is introduced, and electrical contact being made with the n⁺-doped region (7) by means of an electrode which is electrically conductively connected to the cathode terminal (K).

4. Method for producing a controllable power semiconductor component according to one of the preceding claims,
a wafer made of n⁻-doped silicon being used as a substrate, in a first step the n-type buffer zone (2) being applied to the substrate by means of epitaxy, in a second step the n-type buffer zone being connected to a further silicon wafer (9) by bonding, with the result that the mechanical stability is increased, in a third step the cathode-side structure being produced, in a fourth step the further wafer made of silicon being removed by being ground away, and in a last step the p-type emitter zone (3) being produced by implantation.

5. Method for producing a controllable power semiconductor component according to one of the preceding claims,
a wafer made of n⁻-doped silicon being used as a substrate, in a first step the n-type buffer zone (2) being applied to the substrate by means of epitaxy, in a second step the n-type buffer zone (2) being produced by indiffusion of phosphorus atoms, in a third step the cathode-side structure being produced, in a fourth step the further wafer made of silicon being removed by being ground away, and in a last step the p-type emitter zone (3) being produced by implantation.

## Revendications

1. Dispositif semi-conducteur de puissance contrôlable dans lequel sont prévus dans l'ordre une structure du côté cathodique (4 ... 8), présentant à chaque fois une borne de cathode (K) et une borne de grille(G), une zone de base du type N⁻ (1), une zone tampon du type N (2) et une zone d'émetteur du type P (3) mise en contact électrique avec une borne d'anode (A), dans lequel la zone tampon du type N présente une épaisseur située entre 20 et 80 µm et une concentration de dopage sur le bord du côté de l'anode de 8 x 10¹³ à 5 x 10¹⁴ cm⁻³, la zone d'émetteur du type P possédant une épaisseur de 400 à 1000 nm et une concentration de dopage sur le bord du côté de l'anode de 10¹⁷ à 10¹⁸ cm⁻³ et dans lequel la zone de base du type N⁻ (1) présente une durée de vie des porteurs de charge, qui est supérieure à 10 µs.

2. Dispositif semi-conducteur de puissance contrôlable selon la revendication 1, caractérisé en ce que le dispositif semi-conducteur de puissance contrôlable représente un transistor bipolaire à grille isolée, la structure du côté cathodique (4 ... 6) présentant au moins une zone dopée du type N⁺ (5), qui est séparée de la zone de base du type N⁻ (1) par une zone dopée du type P⁺, dans lequel cas au moins une électrode de grille est reliée à la borne de grille (G) et recouvre une partie de la zone dopée du type N⁺ (5)_{,} une partie de la zone dopée du type P⁺ (6) et une partie de la zone de base du type N⁻ (1) et dans lequel l'électrode de grille est séparée de ces zones et de la zone de base du type N⁻ par une couche isolante (4).

3. Dispositif semi-conducteur de puissance contrôlable selon la revendication 1, caractérisé en ce que le dispositif semi-conducteur de puissance contrôlable représente un thyristor, la structure du côté cathodique (7, 8) présentant une zone dopée du type P (8), qui est reliée à la borne de grille (G) et dans laquelle est insérée une zone dopée du type N⁺ (7) et la zone dopée du type N⁺ (7) étant mise en contact électrique avec une électrode, qui est reliée à la borne de cathode (K) en étant conductrice électriquement.

4. Procédé de fabrication d'un dispositif semi-conducteur de puissance contrôlable selon l'une des revendications précédentes, dans lequel une rondelle en silicium dopé du type N⁻ est utilisée comme substrat, la zone tampon du type N (2) étant appliquée par épitaxie sur le substrat dans une première étape, la zone tampon du type N étant reliée à une autre rondelle de silicium (9) par bonding dans une deuxième étape, de sorte que la stabilité mécanique est accrue, dans lequel la structure du côté cathodique est produite dans une troisième étape, l'autre rondelle de silicium étant éliminée par meulage dans une quatrième étape et la zone d'émetteur du type P (3) étant produite par implantation dans une dernière étape.

5. Procédé de fabrication d'un dispositif semi-conducteur de puissance contrôlable selon l'une des revendications précédentes, dans lequel une rondelle en silicium dopé du type N⁻ est utilisée comme substrat, la zone tampon du type N (2) étant appliquée par épitaxie sur le substrat dans une première étape, la zone tampon du type N étant produite par diffusion d'atomes de phosphore dans une deuxième étape, dans lequel la structure du côté cathodique est produite dans une troisième étape, l'autre rondelle de silicium étant éliminée par meulage dans une quatrième étape et la zone d'émetteur du type P (3) étant produite par implantation dans une dernière étape.
